# EUROPEAN PATENT APPLICATION

(11) **EP 4 726 503 A1**
(43) Date of publication of application: **15.04.2026**
(21) Application number: 25208207.8
(22) Date of filing: 13.10.2025
(51) Int. Cl.: G06F 1/28, G01R 31/317

(54) **SYSTEMS AND METHODS FOR POWER MANAGEMENT USING VOLTAGE DROP MONITORING**

(30) Priority: 14.10.2024 US 202418914861
(71) Applicant: Avago Technologies International Sales Pte. Limited, Singapore 768923 (SG)
(72) Inventor: Venkatraman, Ramnath, San Jose, 95129 (US); Castagnetti, Ruggero, Menlo Park, 94025 (US); Sethuraman, Anand, Pleasanton, 94566 (US); Karanam, Girish, 560061 Uttarahalli, Bangalore (IN)
(74) Representative: Dilg, Haeusler, Schindelmann Patentanwaltsgesellschaft mbH

(57) **Abstract**

The subject technology is directed to an apparatus for monitoring voltage changes in electronic systems. In an embodiment, the subject technology provides an apparatus that comprises a voltage monitor, which comprises a signal generator configured to receive a clock signal and generate a reference signal. A first circuit is coupled to the signal generator and is configured to receive the reference signal and generate a first signal by providing a delay to the reference signal. The first circuit includes a first delay path characterized by a first threshold voltage. An edge detector is coupled to the first circuit and is configured to generate a second signal based on a timing difference between the first signal and the reference signal. The system enables accurate real-time detection of voltage fluctuations, contributing to efficient power management and improved performance. There are other embodiments as well.

## Description

### FIELD OF INVENTION

The subject technology is directed to semiconductor devices.

### BACKGROUND OF THE INVENTION

The rapid development of artificial intelligence (AI) technologies has significantly increased the demand for complex and power-intensive chips, such as graphics processing units (GPUs) and tensor processing units (TPUs). These chips consist of arrays of identical cores optimized for parallel processing, which is beneficial for the computationally intensive tasks required in AI applications. However, the parallel nature of these operations increases the power consumption of these chips, presenting challenges for data centers that host AI servers.

The power demands of AI-based computing systems have been further amplified by advancements in semiconductor technology. Methods of transistor scaling, as characterized by Moore's Law, have evolved to accommodate modern chip architectures, including 2.5D and 3D stacking. These advanced architectures allow for higher computational throughput by integrating multiple layers of transistors within a single chip or by placing multiple chips in close proximity. While these techniques increase processing power, they also exacerbate power dissipation challenges in AI-driven environments due to the higher density and power consumption associated with these designs.

Some approaches for voltage monitoring and power management often rely on polling mechanisms or external feedback systems, which introduce delays in detecting and responding to voltage drops. Furthermore, these systems are not always well-suited to managing the complexities of power dissipation in 2.5D and 3D stacked architectures, where heat accumulation and voltage fluctuations are more pronounced due to the proximity of densely packed components.

Various approaches for improving power management in integrated circuits have been explored, but they have proven to be insufficient. It is important to recognize the need for new and improved power management methods and systems.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating a semiconductor device according to embodiments of the subject technology.
Figure 2 is a simplified diagram illustrating a processing unit having a voltage monitor according to embodiments of the subject technology.
Figure 3 is a simplified diagram illustrating a voltage monitor apparatus according to embodiments of the subject technology.
Figure 4 is a simplified diagram illustrating a configuration of delay paths within a voltage monitor apparatus according to embodiments of the subject technology.
Figure 5 is a simplified diagram illustrating an output generated by an edge detector according to embodiments of the subject technology.
Figure 6 is a graph illustrating chip voltage fluctuations over time, showing the minimum voltage recorded during operation, according to embodiments of the subject technology.
Figure 7 is a graph illustrating a method of determining the temperature of a processing unit using one or more delay paths, according to embodiments of the subject technology.
Figure 8 is a graph illustrating a method of programming voltage drop indicator bits, according to embodiments of the subject technology.
Figure 9 is a flow diagram illustrating a method for optimizing power management and performance in a semiconductor device using a voltage monitor, according to embodiments of the subject technology.
Figure 10 is a graph illustrating a method of using programmable parameters to control power-regulation actions based on voltage drop events, according to embodiments of the subject technology.
Figure 11 is a simplified diagram illustrating a semiconductor device according to embodiments of the subject technology.

### DETAILED DESCRIPTION OF THE INVENTION

The subject technology is directed to an apparatus for monitoring voltage changes in electronic systems. In an embodiment, the subject technology provides an apparatus that comprises a voltage monitor. The voltage monitor comprises a signal generator configured to receive a clock signal and generate a reference signal. A first circuit is coupled to the signal generator and is configured to receive the reference signal and generate a first signal by providing a delay to the reference signal. The first circuit includes a first delay path characterized by a first threshold voltage. An edge detector is coupled to the first circuit and is configured to generate a second signal based on a timing difference between the first signal and the reference signal, where the second signal is associated with a voltage change. The system enables accurate real-time detection of voltage fluctuations, contributing to efficient power management and improved performance. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising a voltage monitor, which comprises: a signal generator configured to receive a clock signal and generate a reference signal based on the clock signal; a first circuit coupled to the signal generator, the first circuit being configured to receive the reference signal and generate a first signal by providing a delay to the reference signal, the first circuit comprising a first delay path characterized by a first threshold voltage; and a detector coupled to the first circuit, the detector being configured to generate a second signal based on a timing difference between the first signal and the reference signal, the second signal being associated with a voltage change.

Implementations may include one or more of the following features. The first circuit further comprises a second delay path characterized by a second threshold voltage different from the first threshold voltage. The voltage monitor further comprises a controller coupled to the first circuit, the controller is configured to select the first delay path. The apparatus further comprises an encoder coupled to the detector, the encoder being configured to convert the second signal into a third signal representing a magnitude of the voltage change. The first delay path is characterized by a first length, the voltage monitor further comprises a second circuit coupled to the first circuit, and the second circuit is configured to adjust the first length based at least on the voltage change. The apparatus further comprises a logic unit coupled to the voltage monitor, the logic unit being configured to generate a fourth signal for adjusting an operating parameter based at least on the voltage change. The operating parameter comprises a clock frequency or a supply voltage.

Another general aspect includes an apparatus comprising processing unit, the processing unit comprising a voltage monitor, the voltage monitor comprising: a signal generator configured to receive a clock signal and generate a reference signal; a first circuit coupled to the signal generator, the first circuit being configured to receive the reference signal and generate a first signal by providing a delay to the reference signal; and a detector coupled to the first circuit, the detector being configured to generate a second signal based at least on a first timing difference between the first signal and the reference signal, the second signal being associated with a voltage change in the processing unit.

Implementations may include one or more of the following features. The first circuit comprising a first delay path characterized by a first threshold voltage. The first circuit further comprising a second delay path characterized by a second threshold voltage different from the first threshold voltage. The voltage monitor further comprises a controller coupled to the first circuit, the controller is configured to select the first delay path. The voltage monitor is configured to determine a temperature of the processing unit based at least on the second signal. The processing unit further comprises a logic unit coupled to the voltage monitor, the logic unit being configured to generate a third signal for adjusting an operating parameter of the processing unit based at least on the voltage change. The operating parameter comprises a clock frequency or a supply voltage.

Yet another general aspect includes an apparatus comprising a voltage monitor, the voltage monitor comprising: a signal generator configured to receive a clock signal and generate a reference signal; a first circuit coupled to the signal generator, the first circuit comprising a first delay path configured to receive the reference signal and generate a first signal by providing a delay to the reference signal; and a detector coupled to the first circuit, the detector being configured to generate a second signal based at least on a timing difference between the first signal and the reference signal, the second signal being associated with a voltage change. The voltage monitor further comprises a controller coupled to the first circuit, the controller being configured to select the first delay path. The first delay path is characterized by a first length, the voltage monitor further comprises a second circuit coupled to the first circuit, and the second circuit is configured to adjust the first length. The apparatus further comprises a logic unit coupled to the voltage monitor, the logic unit being configured to generate a third signal for adjusting an operating parameter based at least on the voltage change. The operating parameter comprises a clock frequency or a supply voltage.

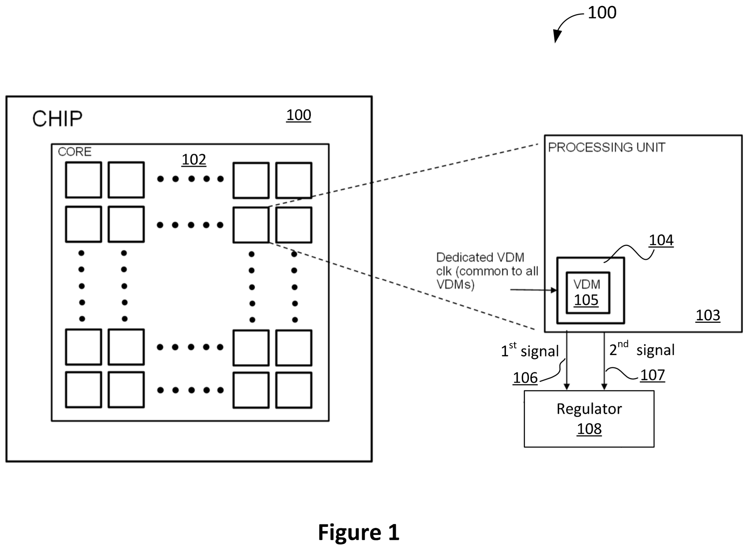

Figure 1 is a simplified diagram illustrating a semiconductor device 100 according to embodiments of the subject technology. This diagram merely provides an example, which should not unduly limit the scope of the claims. One of ordinary skill in the art would recognize many variations, alternatives, and modifications. In various implementations, semiconductor device 100 may include an integrated circuit (IC) designed for various applications such as AI computations, data processing, machine learning (ML), and/or the like. These applications require advanced power management systems due to the high processing demands and the need for efficient energy usage.

In some embodiments, semiconductor device 100 includes core 102. For instance, the term "core" may refer to a central processing area of a semiconductor device responsible for carrying out the main processing tasks. Core 102 can support various operations, such as arithmetic computations, data handling, control logic execution, deep learning, or high-speed data processing. Depending on the implementation, cores may be replicated in semiconductor device 100, enabling parallel processing to enhance performance and efficiency. Core 102 may include, without limitation, general-purpose cores in central processing units (CPUs), specialized cores in graphics processing units (GPUs), or dedicated neural cores designed to accelerate AI operations.

In various examples, core 102 includes an array of processing units. For instance, core 102 includes processing unit 103. The term "processing unit" may refer to a computational unit within a core that executes specific computational tasks. Processing unit 103 may include various functional blocks, such as arithmetic logic units (ALUs), control units, memory registers, and/or the like.

In various implementations, processing unit 103 may include logic unit 104 and voltage monitor 105 (also referred to as a voltage drop monitor, VDM). The term "logic unit" may refer to a functional block responsible for managing computational tasks and handling local processing within the unit. For example, logic unit 104 may include basic computational circuits such as adders, multipliers, control logic, and/or the like. In some examples, logic unit 104 may be configured to perform memory and control functions such as storing, retrieving, and manipulating data.

In some examples, voltage monitor 105 may be coupled to logic unit 104. The term "voltage monitor" or "voltage drop monitor" may refer to a component or circuitry designed to monitor and measure voltage levels within a processing unit. For instance, voltage monitor 105 measures the voltage at different points in processing unit 103, detecting fluctuations or drops in voltage that may affect performance. The voltage fluctuations may be caused by changes in workload or variations in power supply, and voltage monitor 105 helps ensure that processing unit 103 continues to operate reliably by detecting and responding to such changes in real-time. Depending on the implementation, one or more voltage monitors in semiconductor device 100 may share a common clock signal, which operates at a frequency close to or equal to the core functional clock.

Voltage monitor 105 may work in conjunction with logic unit 104 to adjust the supply voltage and/or clock frequency by generating appropriate electrical signals based on detected voltage changes. This ensures that the voltage supplied to processing unit 103 is high enough to maintain functionality without being excessive, which helps minimize power dissipation and optimize overall efficiency. The term "supply voltage" may refer to the electrical potential provided to a circuit or component. In various examples, the supply voltage may range from the core voltage of a processor to the voltage supplied to memory or other subsystems in a device. The term "clock frequency" may refer to the rate at which a clock signal oscillates, determining the speed at which a processor or digital circuit operates. In some examples, voltage monitor 105 detects a fluctuation or drop in voltage and transmits raw data or detection signals to logic unit 104. Logic unit 104 may process data from voltage monitor 105 and generate one or more control signals (e.g., first signal 106 and/or second signal 107) that adjust the operating conditions of processing unit 103 based on the voltage change information.

As an example, logic unit 105 may output first signal 106 and/or second signal 107 for adjusting the operating parameters of processing unit 103. The term "operating parameter" may refer to any adjustable characteristic or setting that influences the performance, power consumption, or functionality of a processing unit. Examples of operating parameters may include, without limitation, supply voltage, clock frequency, power mode, processing speed, temperature threshold, and/or the like.

In some implementations, first signal 106 may include a control signal for adjusting the voltage supplied to processing unit 103, ensuring that it remains within an optimal range for performance without wasting power. Second signal 107 may include a control signal for adjusting the clock frequency of processing unit 103, allowing for dynamic frequency scaling based on the voltage levels and processing demands. These control signals may be transmitted to regulator 108, which may be an on-chip power management component or an external voltage regulator, depending on the implementation. Upon receiving the signals, regulator 108 adjusts the operating parameters (e.g., supply voltage and/or clock frequency) as instructed, ensuring that semiconductor device 100 operates within the desired power and performance parameters.

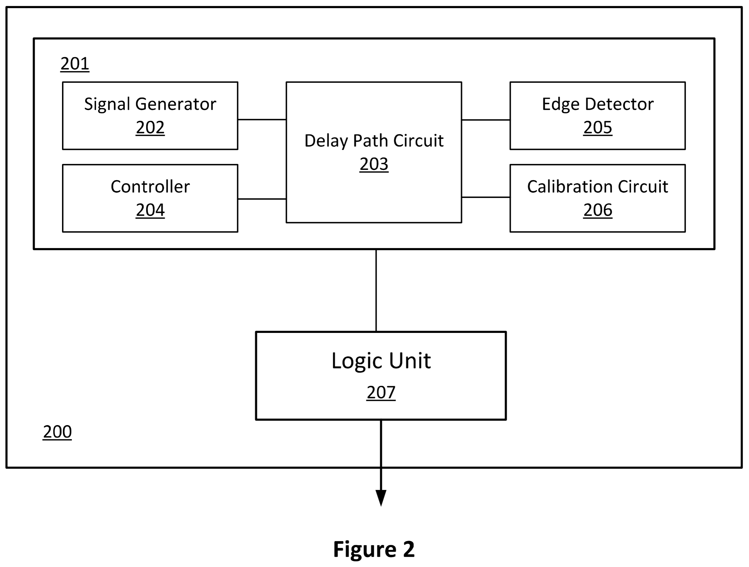

Figure 2 is a simplified diagram illustrating a processing unit 200 having a voltage monitor according to embodiments of the subject technology. This diagram merely provides an example, which should not unduly limit the scope of the claims. One of ordinary skill in the art would recognize many variations, alternatives, and modifications. In various implementations, processing unit 200 may be part of a semiconductor device (e.g., semiconductor device 100 of Figure 1), which may be used for various applications such as AI computations, data processing, or machine learning.

According to some embodiments, processing unit 200 includes voltage monitor 201 and/or logic unit 207, which work in conjunction to detect voltage fluctuations and adjust operating parameters to optimize power consumption and performance. For instance, voltage monitor 201 includes signal generator 202. For example, the term "signal generator" may refer to a component or circuit that generates electrical signals, which may be based on certain input parameters, such as clock signals or voltage levels. Signal generator 202 may generate signals used for synchronization, control, or measurement purposes.

In some implementations, signal generator 202 may be configured to receive a clock signal. The term "clock signal" may refer to a periodic oscillating signal used to synchronize the operations of various components in an electronic system. For instance, the clock signal may regulate the timing of operations in processing unit 200, ensuring that different elements of the system operate in synchrony. In some examples, the clock signal may be derived from a core clock used across the semiconductor device, allowing different processing units to remain synchronized during operation.

In some embodiments, signal generator 202 may be configured to generate a reference signal based on the clock signal. For example, the term "reference signal" may refer to a signal that serves as a baseline for comparison or measurement purposes within the system. The reference signal may maintain a consistent timing or voltage characteristic and serve as a baseline against which other signals are compared to detect any voltage drops or fluctuations.

In various implementations, voltage monitor 201 includes circuit 203 coupled to signal generator 202. Circuit 203 may be configured to receive the reference signal and generate a first signal by providing a delay to the reference signal. In some cases, circuit 203 may also be referred to as a delay path circuit. For instance, the term "delay" may refer to the time taken for an electrical signal to propagate through a circuit or path. In circuit 203, the delay may be introduced to measure changes in the signal's propagation speed, which can be influenced by voltage fluctuations. Voltage influences the switching speed of the transistors or other components within circuit 203. For instance, when the voltage drops, the speed at which the components switch is reduced, thereby increasing the delay. Conversely, when the voltage is stable or increases, the switching speed rises, reducing the delay. The relationship between voltage and delay makes it possible to use the delay as an indicator of voltage changes within the system.

Circuit 203 provides delay information on a time scale comparable to the clock cycle period, ensuring real-time detection of voltage changes. By introducing a delay to the reference signal from signal generator 202, circuit 203 may generate a first signal that is offset in time from the reference signal. The first signal may then be compared with the reference signal to detect how much the delay has changed, thereby providing an indication of voltage change in processing unit 200.

In various implementations, voltage monitor 201 includes controller 204 coupled to circuit 203. For example, the term "controller" may refer to a circuit or component that manages, directs, or regulates the operation of other components within a system. In some examples, controller 204 may be responsible for managing the operation of circuit 203 and controlling its behavior in response to changing conditions (e.g., process, voltage, temperature, and/or the like). For instance, controller 204 may be configured to select or adjust the delay path within circuit 203, as will be described in further detail below.

In some embodiments, voltage monitor 201 includes detector 205 coupled to circuit 203. The term "detector" may refer to a circuit designed to identify and process changes in signal characteristics (e.g., transitions or edges of a signal). For instance, detector 205 may include an edge detector, which is configured to detect and measure the timing difference between signal transitions, such as the rising or falling edges of the reference signal and the first signal generated by circuit 203.

In various examples, detector 205 may be configured to generate a second signal based on a timing difference between the first signal and the reference signal. The term "timing difference" may refer to the interval or discrepancy in time between two related events, such as the transition points (e.g., rising or falling edges) of electrical signals. The timing difference may be indicative of the amount of delay introduced by circuit 203, which is associated with the voltage changes in processing unit 200. The term "voltage change" may refer to any variation in the voltage level supplied to a circuit, such as an increase or decrease in voltage over time. For the purposes of this disclosure, "voltage change" and "voltage drop" may be used interchangeably, depending on the context, to describe fluctuations in voltage.

In some implementations, voltage monitor 201 may further include circuit 206, which may be configured to adjust the parameters of circuit 203 (e.g., the path length of the delay paths) to achieve a baseline reading that can effectively measure voltage drops. In some cases, circuit 206 may also be referred to as a calibration circuit. The calibration ensures that a balanced baseline reading is maintained for accurate detection of voltage changes. Depending on the implementation, calibration may be performed during periods of low chip activity, allowing the system to establish a stable baseline under quiescent conditions. Once calibrated, circuit 206 ensures that the system can measure voltage drops with high accuracy during normal operating conditions, where voltage fluctuations may affect the performance of processing unit 200.

In various implementations, logic unit 207 may receive the second signal from detector 205, which reflects voltage changes within processing unit 200. Logic unit 207 may be configured to interpret the second signal and determine whether corrective action is needed to optimize power consumption or performance. For instance, if the voltage fluctuation detected by voltage monitor 201 indicates a voltage drop, logic unit 207 may generate a control signal to optimize power management. In some implementations, logic unit 207 may communicate with a voltage regulator or clock management circuit to adjust voltage or clock frequency.

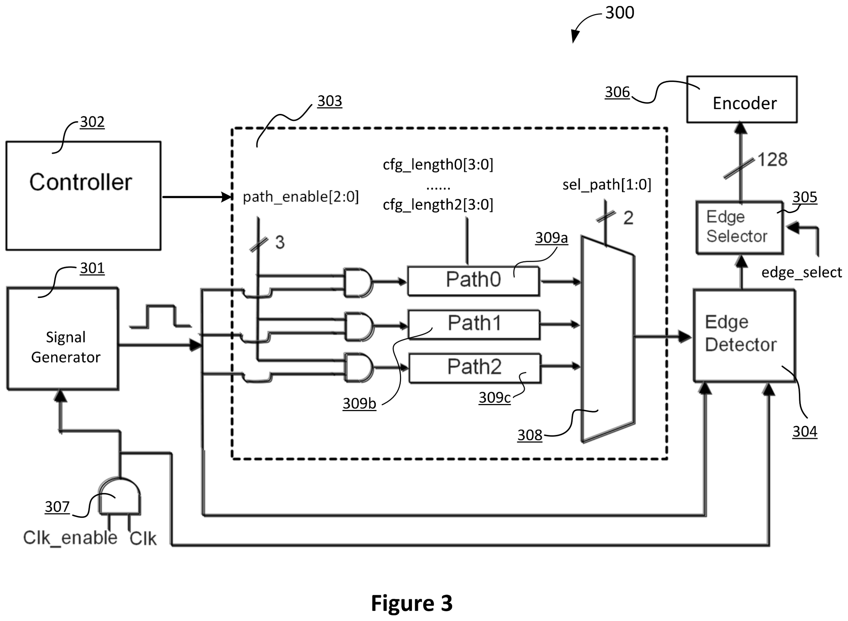

Figure 3 is a simplified diagram illustrating a voltage monitor apparatus 300 according to embodiments of the subject technology. This diagram merely provides an example, which should not unduly limit the scope of the claims. One of ordinary skill in the art would recognize many variations, alternatives, and modifications.

In some embodiments, voltage monitor 300 may include signal generator 301, which may be configured to receive a clock signal from clock source 307. For instance, clock source 307 may include, without limitation, an internal oscillator, a phase-locked loop (PLL), an external clock generator, and/or the like. In some examples, clock source 307 may include a dedicated system clock that provides a reference frequency for the entire semiconductor device. In some embodiments, signal generator 301 may be configured to generate a reference signal based on the clock signal. The reference signal may serve as a baseline against which other signals are compared to detect any voltage drops or fluctuations.

In various implementations, voltage monitor 300 includes circuit 303 coupled to signal generator 301. Circuit 303 may be configured to receive the reference signal and generate a first signal by providing a delay to the reference signal. The delay introduced by circuit 303 provides an indication of voltage changes within the semiconductor device. In some examples, circuit 303 may include one or more delay paths, each characterized by different threshold voltages or configurations (e.g., path length), allowing it to adapt to various operating conditions (e.g., process, voltage, temperature, and/or the like). The term "delay path" may refer to an electrical path or circuit that introduces a measurable delay to a signal's propagation.

In the embodiment illustrated in Figure 3, circuit 303 includes three delay paths: first delay path 309a (e.g., path0), second delay path 309b (e.g., path1), and third delay path 309c (e.g., path2). The internal elements of delay paths may include, without limitation, transistor-based logic circuits, resistive-capacitive (RC) circuits, or other delay-inducing components that ensure a measurable time difference is introduced to the reference signal as it propagates through each path.

The delay paths may be characterized by different threshold voltages and/or lengths. The term "threshold voltage" may refer to the minimum voltage level required to activate the transistors or other switching elements within a delay path. The threshold voltage determines the sensitivity of the delay path to voltage changes. For instance, a lower threshold voltage may allow the delay path to be more sensitive to smaller fluctuations in voltage, while a higher threshold voltage could make the path less sensitive to minor voltage variations but more stable under certain conditions. In some examples, first delay path 309a may be characterized by a first threshold voltage. Second delay path 309b may be characterized by a second threshold voltage different from the first threshold voltage.

The term "length" or "path length" may refer to the physical or electrical distance that a signal must travel through a given circuit path. By designing delay paths with varying lengths, the system can fine-tune the sensitivity and resolution of the voltage monitoring process. By incorporating one or more delay paths with varying threshold voltages and lengths, the system can adapt to different operating conditions. This allows voltage monitor 300 to operate across a wide range of voltages, enabling an adaptive voltage monitoring system that can cater to a wide range of operating conditions.

In some implementations, only one delay path may be selectable at a time based on the operating conditions of the semiconductor device. The ability to select a particular delay path based on the process, voltage, or temperature (PVT) conditions ensures that circuit 303 can adjust its sensitivity and resolution to the specific operating conditions. The selection process may be managed by multiplexer 308, which is configured to receive a control signal (e.g., sel_path[1:0]) and route the reference signal through the selected delay path, which then generates a delayed signal (e.g., the first signal) used for monitoring voltage changes within the system.

In various embodiments, voltage monitor 300 further includes controller 302 coupled to circuit 303. Controller 302 may be configured to manage the operation of the delay paths within circuit 303. For instance, controller 302 may generate one or more control signals (e.g., path_enable[2:0] and/or cfg_length0[3:0] through cfg_length2[3:0]), to control the enablement of specific delay paths and configure their lengths based on the system's operational needs. Depending on the implementation, the delay paths in circuit 303 may be length-configurable, providing flexibility in adapting to different clock frequencies and PVT conditions.

According to some embodiments, voltage monitor 300 further includes detector 304 coupled to circuit 303. For instance, detector 304 may include an edge detector, which is configured to detect and measure the timing difference between signal transitions, such as the rising or falling edges of the reference signal and the first signal generated by circuit 303. Detector 304 may be configured to generate a second signal based on a timing difference between the first signal and the reference signal. The timing difference is indicative of the amount of delay introduced by circuit 303, which is associated with the voltage changes in the processing unit.

In various implementations, the output of detector 304 (e.g., the second signal) may provide feedback on the voltage conditions within the semiconductor device. The second signal may represent the degree of delay introduced by the selected delay path in circuit 303, which corresponds to a voltage change. In some cases, the second signal may consist of a series of binary values (e.g., a sequence of 1s followed by a sequence of 0s), where the length of the series of 1s correlates to the magnitude of the voltage drop detected.

In some examples, the second signal may be processed further by edge selector 305, which is coupled to detector 304. The term "edge selector" may refer to a component or circuit designed to isolate and select specific transitions or edges of signals. For instance, edge selector 305 may receive the second signal from detector 304 and isolate a particular edge (e.g., rising or falling edge) to refine the detection of voltage changes.

In various embodiments, voltage monitor 300 further includes encoder 306. The term "encoder" may refer to a component or circuit that converts one form of data into another. For instance, encoder 305 may be configured to convert the second signal into a third signal representing a magnitude of the voltage change. In some cases, encoder 306 may include logic circuitry for calculating binary values that are proportional to the instantaneous voltage drop. In an example, encoder 306 may be configured to take the output from detector 304 (e.g., the second signal) and convert it into a binary format. This conversion simplifies the representation of the detected voltage fluctuation, making it easier to process and interpret within the system.

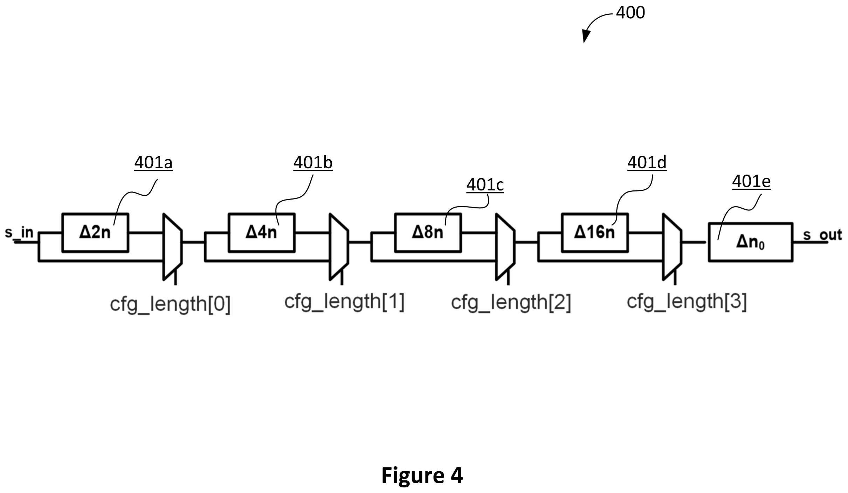

Figure 4 is a simplified diagram illustrating a configuration of delay path 400 within a voltage monitor apparatus according to embodiments of the subject technology. This diagram merely provides an example, which should not unduly limit the scope of the claims. One of ordinary skill in the art would recognize many variations, alternatives, and modifications. In various implementations, delay path 400 may be part of a delay path circuit (e.g., circuit 303 of Figure 3) designed to measure voltage fluctuations in a semiconductor device.

As shown, delay path 400 may include a series of configurable delay stages (e.g., 401a-e), each of which introduces an incremental delay to an input signal (e.g., s_in) as it propagates through the path to generate an output signal (e.g., s_out). In various implementations, delay path 400 may be configured to various lengths using control signals (e.g., cfg_length[3:0]). These control signals determine how many delay stages are included in the path that the signal traverses from the input to the output. The flexibility in path length allows the system to adjust its sensitivity to voltage fluctuations. In an example, the length of the delay path 400 can be adjusted up to 16 different lengths, as shown in Figure 4, to ensure that the voltage monitor can maintain accurate measurements across a wide range of operational parameters.

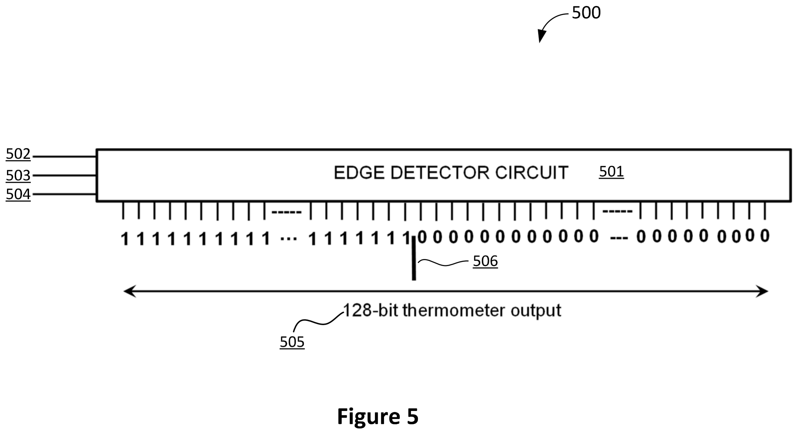

Figure 5 is a simplified diagram illustrating a 128-bit output generated by a voltage monitor 500 according to embodiments of the subject technology. This diagram merely provides an example, which should not unduly limit the scope of the claims. One of ordinary skill in the art would recognize many variations, alternatives, and modifications.

As shown, voltage monitor 500 includes detector 501, which may be coupled to different components within voltage monitor 500. For example, detector 501 is configured to receive one or more signals (e.g., signals 502, 503, and 504) representing voltage-related information from different delay paths (e.g., delay paths 309a-c of Figure 3) within voltage monitor 500. These signals may be processed by detector 501 to evaluate the timing differences between the reference signal and the delayed signal generated by the delay path circuit (e.g., circuit 303 of Figure 3).

In various examples, detector 501 may output a thermometer-style reading, represented as a binary sequence (e.g., 128-bit). For instance, output signal 505 of detector 501 may include a series of 1s followed by a series of 0s, where the number of 1s corresponds to the magnitude of the detected voltage drop. The location of boundary 506 between the series of 1s and 0s serves as an indicator of the propagation speed of the signal through the delay path, which is associated with voltage levels in the semiconductor device.

Voltage monitors may operate in various modes depending on the system's operational state and the desired monitoring behavior. These modes provide flexibility in tracking and analyzing voltage behavior, enabling the system to adjust power settings in real-time and/or record voltage data for informational and diagnostic purposes. For instance, in a first mode (which may also be referred to as real-time voltage monitoring), the voltage monitor polls voltage drop information at regular intervals while the semiconductor device is in functional mode. The first mode allows the system to monitor the voltage change in real-time and make immediate adjustments to operating parameters such as voltage and clock frequency for power optimization.

A second mode (which may also be referred to as worst-case voltage monitoring) may be used to capture the worst-case voltage drop over a selected time interval while the semiconductor device is operating in functional mode. In this mode, the voltage monitor may enable a feature called sticky_mode, which holds the minimum voltage reading recorded during the monitoring period. This ensures that the lowest voltage point experienced during the operation is preserved for informational purposes. The second mode may be useful for post-operation analysis or debugging where the system's voltage behavior under different operating conditions can be assessed.

A third mode (which may also be referred to as test mode) may be used during diagnostics and testing procedures, such as scan tests or transition delay fault (TDF) tests. In this mode, the sticky_mode feature may be enabled, and the voltage monitor captures and holds the lowest voltage drop experienced during the test. The third mode may be used for data collection and debugging purposes, providing information about the voltage characteristics of the semiconductor device under controlled test conditions.

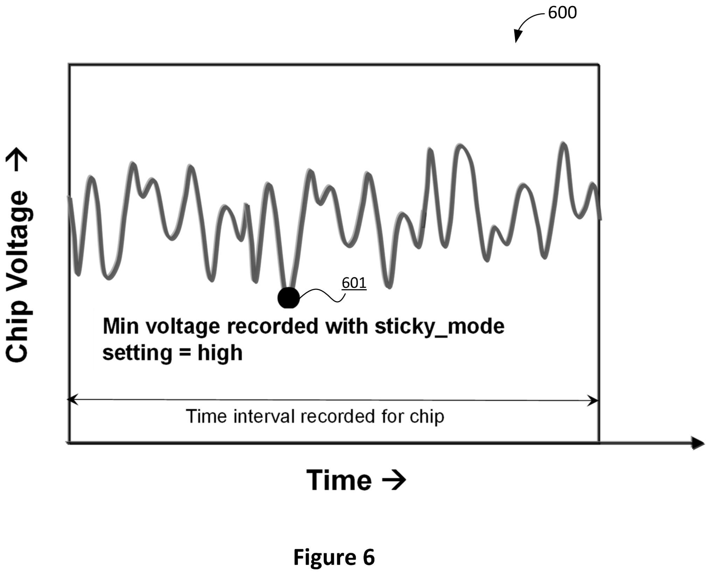

Figure 6 is a graph 600 illustrating chip voltage fluctuations over time, showing the minimum voltage recorded during operation, according to embodiments of the subject technology. This diagram merely provides an example, which should not unduly limit the scope of the claims. One of ordinary skill in the art would recognize many variations, alternatives, and modifications. As shown, the sticky_mode feature may be enabled in the second or third, where the voltage monitor captures and holds the lowest voltage drop recorded during the monitoring period. The captured minimum voltage 601 provides an indication of the lowest point reached during the monitoring period, ensuring that even transient voltage dips can be preserved for subsequent analysis.

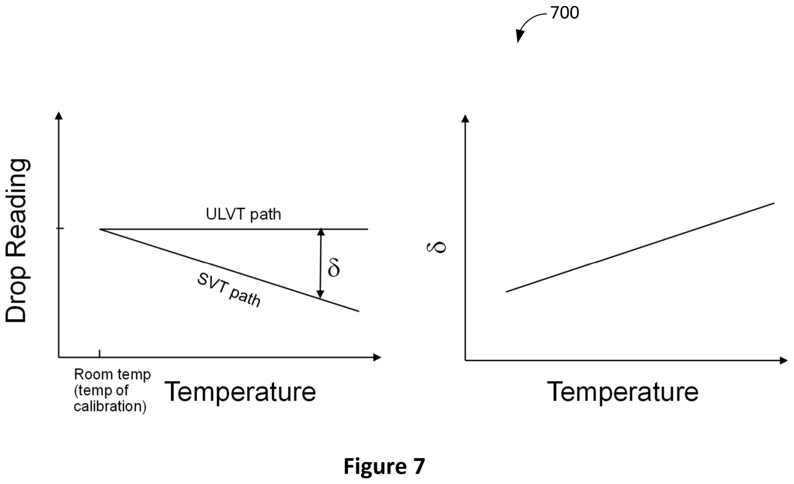

Figure 7 is a graph 700 illustrating a method of determining the temperature of a processing unit using one or more delay paths, according to embodiments of the subject technology. This diagram merely provides an example, which should not unduly limit the scope of the claims. One of ordinary skill in the art would recognize many variations, alternatives, and modifications.

In various implementations, a voltage monitor may be configured to determine a temperature of the processing unit. For example, the delay behavior of different delay paths varies with temperature due to the impact of temperature on transistor mobility and threshold voltage (e.g., Vt). For the delay paths with higher threshold voltages (e.g., SVT path), as temperature increases, the reduction in threshold voltage dominates, causing the path to speed up. In contrast, for paths with lower threshold voltages (e.g., ULVT path), the reduction in mobility due to increasing temperature has a greater impact than the reduction in threshold voltage, causing the path to slow down. By comparing the delays of different paths (e.g., SVT and ULVT paths), the voltage monitor can infer the temperature of the processing unit. The difference in voltage drop (e.g., represented as "δ" in Figure 7) between these paths may serve as an indicator of the temperature. In some examples, the system may be calibrated at room temperature (or another reference temperature) so that any systematic changes in the voltage drop between the delay paths can be used to detect temperature fluctuations.

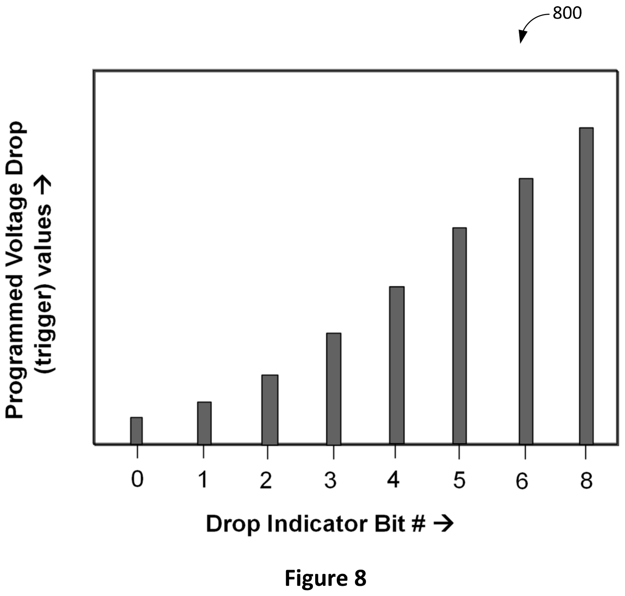

Figure 8 is a graph 800 illustrating a method of programming voltage drop indicator bits, according to embodiments of the subject technology. This diagram merely provides an example, which should not unduly limit the scope of the claims. One of ordinary skill in the art would recognize many variations, alternatives, and modifications.

In various embodiments, the system may utilize pre-programmed voltage drop indicator bits to enable immediate detection of voltage drops within the semiconductor device. Each indicator bit is configured with a specific voltage drop threshold, allowing the system to respond rapidly to varying levels of voltage drop. As shown in Figure 8, bits 0 through 8 may be programmed with increasing voltage drop thresholds, ensuring that a wide range of voltage drops can be monitored in real time. When a voltage drop event occurs, the corresponding drop indicator bit is triggered, generating a signal to initiate corrective actions, such as adjusting the voltage or clock frequency to stabilize the system. The immediate response ensures fast and efficient power management, reducing the potential for system instability caused by power fluctuations.

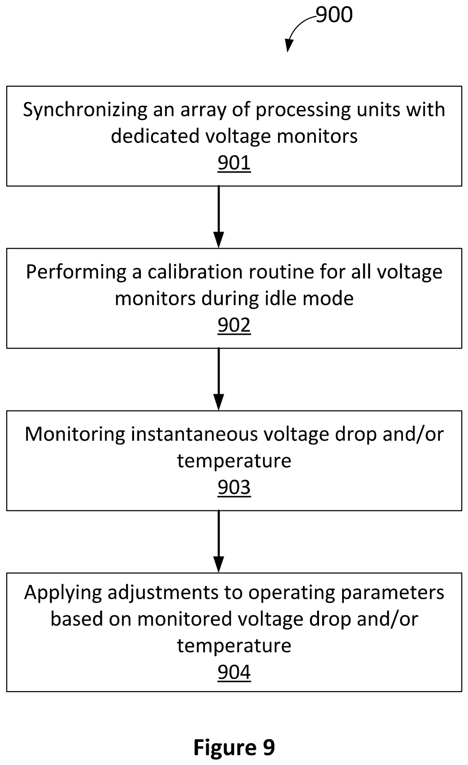

Figure 9 is a flow diagram illustrating a method 900 for optimizing power management and performance in a semiconductor device using a voltage monitor, according to embodiments of the subject technology. This diagram merely provides an example, which should not unduly limit the scope of the claims. One of ordinary skill in the art would recognize many variations, alternatives, and modifications.

At step 901, method 900 may include synchronizing an array of processing units with dedicated voltage monitors. Each voltage monitor may be supplied with a fixed-frequency clock to maintain synchronization across the array. The synchronization ensures that all voltage monitors within the system are working based on the same fixed-frequency clock, allowing for consistent voltage measurements across the entire semiconductor device.

At step 902, method 900 may include performing a calibration routine for all voltage monitors during idle mode. The calibration process may be performed under quiescent chip conditions to establish a reference voltage for each voltage monitor, providing a baseline for future monitoring.

At step 903, method 900 may include monitoring instantaneous voltage drop and/or temperature. For instance, during functional mode, the array of voltage monitors continuously monitors the voltage drop across the processing units on a cycle-by-cycle basis. This allows the system to capture any fluctuations in voltage in real-time and detect temperature variations that could affect the performance of the semiconductor device.

At step 904, method 900 may include applying adjustments to operating parameters based on monitored voltage drop and/or temperature. The adjustments may involve dynamically modifying the voltage supply, clock frequency, or other operating parameters of the processing units to maintain stable and efficient operation. By applying these adjustments in response to the monitored data, the system can maintain consistent performance under varying workload conditions and prevent performance degradation caused by voltage or thermal fluctuations.

In various implementations, the adjustments of operating parameters may involve scaling the clock frequency, voltage supply, or both to ensure the processing units operate within the desired power and performance range. These adjustments may be based on the real-time data collected from the voltage monitors, which continuously track the fluctuations in voltage and/or temperature across the processing units. For instance, in frequency scaling scenarios, the system may adjust the clock frequency while maintaining a constant voltage supply. This approach is useful when minor adjustments in processing speed are needed to address workload variations without increasing power consumption. By lowering or increasing the clock frequency in response to the monitored data, the system can prevent overloading the processing unit and maintain efficient performance. In frequency and voltage scaling scenarios, the system may adjust both the clock frequency and the voltage supply to ensure power efficiency.

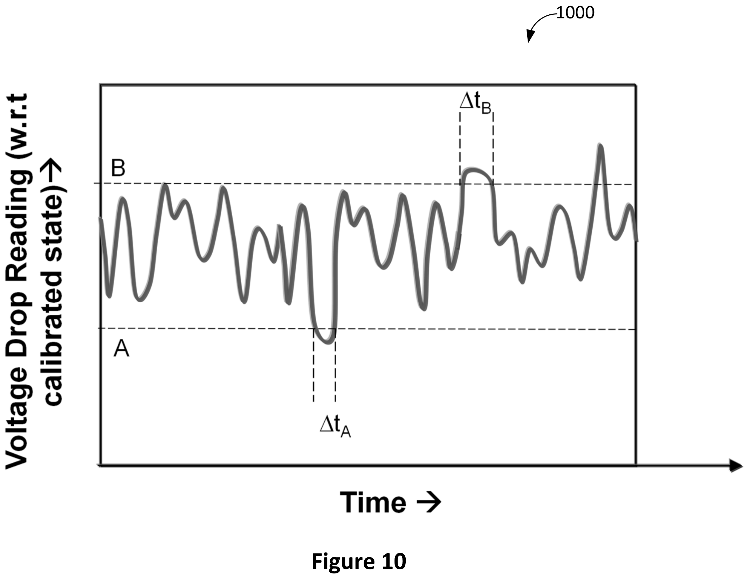

Figure 10 is a graph 1000 illustrating a method of using programmable parameters to control power-regulation actions based on voltage drop events, according to embodiments of the subject technology. This diagram merely provides an example, which should not unduly limit the scope of the claims. One of ordinary skill in the art would recognize many variations, alternatives, and modifications. In various embodiments, a logic unit (e.g., logic unit 207 of Figure 2) may include a register bank that stores user-defined settings for voltage and frequency scaling. The stored settings may include programmable parameters such as voltage thresholds and time intervals for triggering and halting power-regulation actions.

In some examples, the system may be programmed with threshold parameters to trigger power-regulating actions when certain conditions are met. As shown in Figure 10, the time interval Δt_{A} may represent a time interval over which a voltage drop must persist for the system to activate a power-regulation action. If the voltage drop lasts longer than Δt_{A}, the logic unit may initiate a power-saving or throttling mechanism to stabilize system performance. In some embodiments, the system may be programmed with an upper voltage limit and a corresponding time interval Δt_{B} after which the mitigating power-throttling routine can be turned off. This allows the system to revert to normal operation after the voltage stabilizes, ensuring the power-regulation mechanisms are not unnecessarily active.

In various implementations, the logic unit may be engineered to enhance debugging capabilities by incorporating a register bank that continuously records a pre-determined number of clock cycles worth of voltage monitor data. In the event of a functionality issue on the chip, the recorded values can be read out and analyzed to help debug the cause of the failure.

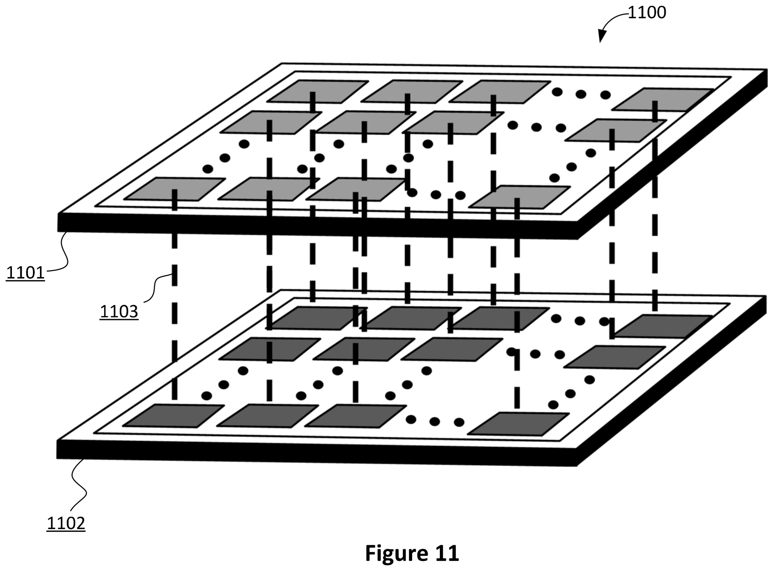

Figure 11 is a simplified diagram illustrating a semiconductor device 1100 according to embodiments of the subject technology. This diagram merely provides an example, which should not unduly limit the scope of the claims. One of ordinary skill in the art would recognize many variations, alternatives, and modifications.

In various implementations, semiconductor device 1100 may include first circuit 1101 and second circuit 1102 stacked in a 3D configuration. First circuit 1101 may represent a primary processing unit, which may include elements such as processing cores, logic units, or other digital components. Second circuit 1102 may serve as a supporting circuit and may include power management components such as voltage regulators, phase-locked loops (PLLs), or other circuits responsible for controlling and optimizing the power supply to first circuit 1101. The vertical stacking of these circuits allows for efficient communication between the two, enabling second circuit 1102 to monitor and regulate the power conditions of first circuit 1101.

In some examples, first circuit 1101 may include a voltage monitor (e.g., voltage monitor 201 of Figure 2) configured to monitor voltage fluctuations in real-time. The voltage monitor can send signals to second circuit 1102, where adjustments to the power supply-such as modulating the output of voltage regulators-can be made to ensure stable and efficient operation of the semiconductor device 1100.

In some embodiments, second circuit 1102 may include a logic unit (e.g., logic unit 207 of Figure 2), which may include programmable algorithms for managing voltage and frequency scaling. The logic unit be used to adjust the operating conditions of the first circuit 1101 by controlling the supply voltage and clock frequency based on real-time monitoring data. In some cases, second circuit 1102 may host clock sources, such as PLLs, to control the frequency of first circuit 1101, allowing different processing units to be tuned to their optimal operating conditions.

In various implementations, first circuit 1101 and second circuit 1102 are connected via interconnect 1103, which allows data and control signals to flow between the two circuits. This ensures that second circuit 1102 can adjust the power supply and clock frequency of first circuit 1101 in real-time, optimizing the overall performance and power efficiency of the semiconductor device 1100.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising a voltage monitor, the voltage monitor comprising:
a signal generator configured to receive a clock signal and generate a reference signal based on the clock signal;
a first circuit coupled to the signal generator, the first circuit being configured to receive the reference signal and generate a first signal by providing a delay to the reference signal, the first circuit comprising a first delay path **characterized by** a first threshold voltage; and
a detector coupled to the first circuit, the detector being configured to generate a second signal based on a timing difference between the first signal and the reference signal, the second signal being associated with a voltage change.

2. The apparatus of claim 1, wherein
the first circuit further comprises a second delay path **characterized by** a second threshold voltage different from the first threshold voltage.

3. The apparatus of claim 1 or 2, wherein
the voltage monitor further comprises a controller coupled to the first circuit, the controller is configured to select the first delay path.

4. The apparatus of any one of the claims 1 to 3, further comprising
an encoder coupled to the detector, the encoder being configured to convert the second signal into a third signal representing a magnitude of the voltage change.

5. The apparatus of any one of the claims 1 to 4, wherein
the first delay path is **characterized by** a first length,
the voltage monitor further comprises a second circuit coupled to the first circuit, and
the second circuit is configured to adjust the first length based at least on the voltage change.

6. The apparatus of any one of the claims 1 to 5, further comprising
a logic unit coupled to the voltage monitor, the logic unit being configured to generate a fourth signal for adjusting an operating parameter based at least on the voltage change;
wherein in particular
the operating parameter comprises a clock frequency or a supply voltage.

7. An apparatus comprising a processing unit, the processing unit comprising a voltage monitor, the voltage monitor comprising:
a signal generator configured to receive a clock signal and generate a reference signal;
a first circuit coupled to the signal generator, the first circuit being configured to receive the reference signal and generate a first signal by providing a delay to the reference signal; and
a detector coupled to the first circuit, the detector being configured to generate a second signal based at least on a first timing difference between the first signal and the reference signal, the second signal being associated with a voltage change in the processing unit.

8. The apparatus of claim 7, wherein
the first circuit comprising a first delay path **characterized by** a first threshold voltage;
wherein in particular
(A) the first circuit further comprising a second delay path **characterized by** a second threshold voltage different from the first threshold voltage; and/or
(B) the voltage monitor further comprises a controller coupled to the first circuit, the controller is configured to select the first delay path.

9. The apparatus of claim 7 or 8, wherein
the voltage monitor is configured to determine a temperature of the processing unit based at least on the second signal.

10. The apparatus of any one of the claims 7 to 9, wherein
the processing unit further comprises a logic unit coupled to the voltage monitor,
the logic unit being configured to generate a third signal for adjusting an operating parameter of the processing unit based at least on the voltage change;
wherein in particular
the operating parameter comprises a clock frequency or a supply voltage.

11. An apparatus comprising a voltage monitor, the voltage monitor comprising:
a signal generator configured to receive a clock signal and generate a reference signal;
a first circuit coupled to the signal generator, the first circuit comprising a first delay path configured to receive the reference signal and generate a first signal by providing a delay to the reference signal; and
a detector coupled to the first circuit, the detector being configured to generate a second signal based at least on a timing difference between the first signal and the reference signal, the second signal being associated with a voltage change.

12. The apparatus of claim 11, wherein
the voltage monitor further comprises a controller coupled to the first circuit, the controller being configured to select the first delay path;
and/or wherein
the first delay path is **characterized by** a first length, the voltage monitor further comprises a second circuit coupled to the first circuit, and the second circuit is configured to adjust the first length.

13. The apparatus of claim 11 or 12, further comprising
a logic unit coupled to the voltage monitor, the logic unit being configured to
generate a third signal for adjusting an operating parameter based at least on the voltage change.

14. The apparatus of claim 13, wherein
the operating parameter comprises a clock frequency.

15. The apparatus of claim 13, wherein
the operating parameter comprises a supply voltage.
